# EUROPÄISCHE PATENTANMELDUNG

(11) **EP 0 818 752 A2**
(43) Veröffentlichungstag der Anmeldung: **14.01.1998**
(21) Anmeldenummer: 97110443.5
(22) Anmeldetag: 26.06.1997
(51) Int. Cl.: G06K 19/077

(54) **Leiterplatte (Inlet) für Chip-Karten**

(30) Priorität: 08.07.1996 CH 1697/96
(71) Anmelder: Fela Holding AG, 8512 Thundorf (CH)
(72) Erfinder: Uhlmann, Ernst, 9507 Stettfurt (CH)
(74) Vertreter: Petschner, Goetz

(57) **Zusammenfassung**

Die Leiterplatte (Inlet) aus vorzugsweise thermoplastischem Kunststoff für Chip-Karten besteht aus einer, eine Kontaktseite (1) und eine Montageseite (3) aufweisenden, beidseitig metallisierten Folie, wobei auf der metallisierten Kontaktseite (1) Kontaktflächen (2) entsprechend der Norm der äusseren Anschlusskontakte und auf der metallisierten Montageseite (3) Anschlusskontakte (4) für den Chip (5) sowie Leiterbahnen (6) für die Spule sowie eine Leiterbahn (7) für den Spulenanschluss an den Chip angeordnet sind, wobei ferner die Durchkontaktierung zwischen den metallisierten Kontaktseite (1) und Montageseite (3) durch Bohrungen (8) im Trägermaterial hindurch erfolgt und wobei der Chip in flip-chip-Technik resp. ohne wire-bond-Verbindung mittels Leitkleber montiert ist.

Ein solches Inlet ist rationell und damit äusserst kostengünstig herzustellen und erlaubt sowohl eine Kontaktierung des oder der Chips der Chip-Karte über genormte Anschlusskontakte als auch einen kontaktlosen Informationsaustausch über eine induktive Ankopplung oder über Radiowellen. Hierbei eignet sich eine solche Leiterplatte als sogenanntes Kombi-Inlet für die Herstellung einer Chip-Karte sowohl durch Laminieren als auch durch Umspritzen.

## Beschreibung

Die vorliegende Erfindung betrifft eine Leiterplatte (Inlet) für Chip-Karten.

Die EP-Patentanmeldung 95116717.0 der gleichen Anmelderin beschreibt eine laminierte kontaktbehaftete oder kontaktlose Chip-Karte (Smart-Card) aus mindestens zwei, einen Chip umgebenden Folien aus thermoplastischem Kunststoffmaterial, die unter Druck und Hitze zusammengefügt sind, wobei der Chip auf einer der Folien fest angeordnet und von einer weiteren, entsprechend gelochten Kern-Folie umgeben ist. Hierbei kann eine der Folien als Substrat resp. Leiterplatte durch Metallisieren und Strukturieren oder Aufdrucken ausgebildet und der Chip auf dieser in flip-chip-Technik resp. ohne wire-bond-Verbindung mittels einem, beim Laminieren aushärtenden Leitkleber montiert sein oder es kann eine Basis-Folie auf der Aussenseite Leiterbahnen aufweisen, die mit den Anschlüssen für den Chip auf der Innenseite des Substrates durch mit Leiterkleber gefüllte Durchkontaktierungsbohrungen verbunden sind. Hierbei können zusätzliche, eine Antennen-Spule bildende Leiterbahnen angeordnet sein.

Diese Massnahmen gestatten u.a., auf die bisherige Komponente eines Moduls vollständig zu verzichten, womit auch das bisher kostspielige und ernergieintensive Aufbringen und Aushärten der Vergussmasse zum Schutze der Chip-Anschlüsse völlig entfällt. Weiter ist ausgeführt, dass man die Merkmale der Chip-Karte mit Kontakten sowie die Merkmale der kontaktlosen Chip-Karte miteinander kombinieren könnte.

Aufgabe der vorliegenden Erfindung ist nun die Schaffung einer Leiterplatte (Inlet) für Chip-Karten, die sowohl eine Kontaktierung des oder der Chips der Chip-Karte über genormte Anschlusskontakte ermöglicht, als auch einen kontaktlosen Informationsaustausch über eine induktive Ankopplung oder über Radiowellen ermöglicht, wobei sich ein solches sogenanntes Kombi-Inlet für die Herstellung einer Chip-Karte sowohl durch Laminieren als auch durch Umspritzen eignet.

Dies wird erfindungsgemäss nun dadurch erreicht, dass die Leiterplatte aus einer, eine Kontaktseite und eine Montageseite aufweisenden, beidseitig metallisierten Folie besteht, wobei auf der metallisierten Kontaktseite Kontaktflächen entsprechend der Norm der äusseren Anschlusskontakte und auf der metallisierten Montageseite Anschlusskontakte für den Chip sowie Leiterbahnen für die Spule sowie eine Leiterbahn für den Spulenanschluss an den Chip angeordnet sind, wobei ferner die Durchkontaktierung zwischen den metallisierten Kontaktseite und Montageseite durch Bohrungen im Trägermaterial hindurch erfolgt und wobei der Chip in flip-chip-Technik resp. ohne wire-bond-Verbindung mittels Leitkleber montiert ist.

Bei einer bevorzugten Ausgestaltung der erfindungsgemässen Leiterplatte können die Kontaktfläshen auf der Kontaktseite sowie die Anschlusskontakten für den Chip, die Leiterbahnen für die Spule und die Leiterbahn zum Anschluss der Spule an den Chip durch Fotolithographie oder Siebdruck hergestellt sein.

Ferner kann bevorzugt die Durchkontaktierung zwischen den metallisierten Kontaktseite und Montageseite chemisch oder mittels Leiterpaste hergestellt sein. Zudem kann die flip-chip-Technik mittels eines Polymer erfolgen, dessen Kontaktflächen Bumps aufweisen und/oder, für eine punktierte Verklebung mit Leitkleber, Bumps an den Anschlussflächen des Chips ausgebildet sein können in Form einer galvanisch oder chemisch aufgebrachten Überhöhung aus Gold, Kupfer oder Nickel oder einer Golddrahtauflage o. dgl..

Durch diese Massnahmen ist es nunmehr möglich, ein solches Inlet, das sowohl eine Kontaktierung des oder der Chips der Chip-Karte über genormte Anschlusskontakte als auch einen kontaktlosen Informationsaustausch über eine induktive Ankopplung oder über Radiowellen erlaubt, rationell und damit äusserst kostengünstig herzustellen. Zudem eignet sich eine solche Leiterplatte als sogenanntes Kombi-inlet für die Herstellung einer Chip-Karte sowohl durch Laminieren als auch durch Umspritzen.

Eine beispielsweise Ausführungsform des Erfindungsgegenstandes ist nachfolgend anhand der Zeichnung näher erläutert. Es zeigen:
- Fig. 1 und 2: in Draufsicht und Seitenansicht eine Leiterplatte (Inlet) für Chip-Karten in wenigstens angenähert natürlicher Grösse;
- Fig. 3: in Draufsicht die Unterseite der Leiterplatte gemäss Fig. 1;
und
- Fig. 4: einen Querschnitt durch die Leiterplatte gemäss Fig. 1 bis 3 im Bereich des Chips, in grösserem Massstab.

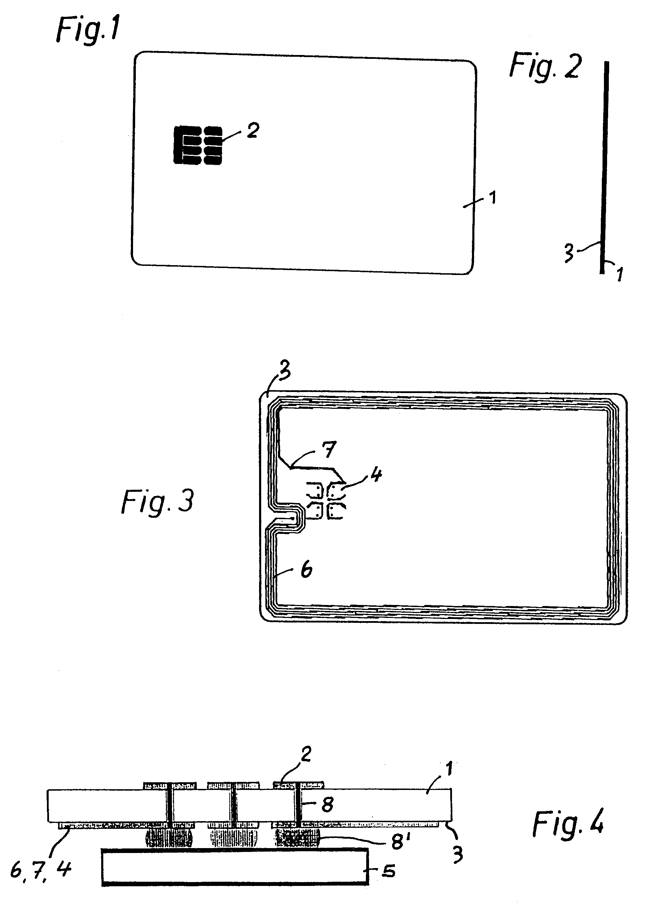

Die erfindungsgemässe Leiterplatte (Inlet) für eine Chip-Karte, hier mit einem Chip, gemäss den Fig. 1 bis 4, besteht vorzugsweise aus einer beidseitig metallisierten Folie aus vorzugsweise thermoplastischem Kunststoff, wie PVC (Polyvinylchlorid), PET (Polycarbonat), ABS (Acrylnitrit-Butadien-Styrol), PC (Polycarbonat) u. a., sowie Mischformen und modifizierte Grundmaterialien, wie PC/ABS, PETG, APET, PMMA u. dgl..

Das Inlet ist auf seiner metallisierten sogenannten Kontaktseite 1 gemäss Fig. 1 durch Fotolithographie oder Siebdruck mit Kontaktflächen entsprechend der Norm der äusseren Anschlusskontakte mit Kontaktflächen 2 versehen.

Auf seiner metallisierten sogenannten Montageseite 3 gemäss Fig. 3 ist das Inlet hingegen, ebenfalls durch Fotolithographie oder Siebdruck oder dgl., mit den Anschlusskontakten 4 für den Chip 5 (Fig. 4) sowie mit Leiterbahnen 6 für die Spule sowie einer Leiterbahn 7 zu deren Anschluss an den Chip versehen.

Die Durchkontaktierung zwischen den metallisierten Kontaktseite 1 und Montageseite 3 erfolgt durch Bohrungen 8 durch das Trägermaterial des Inlet hindurch chemisch oder mittels Leiterpaste.

Dann kann der Chip 5 in der sogenannten Polymer-flip-chip-Technik resp. ohne wire-bond-Verbindung mittels Leitkleber montiert werden, wie Fig. 4 näher veranschaulicht. Für diese flip-chip-Technik weisen die Kontaktflächen des Polymer sogenannte Bumps 8' auf und/oder die Bumps sind an den Anschlussflächen des Chips ausgebildet in Form einer galvanisch oder chemisch aufgebrachten Überhöhung aus Gold, Kupfer oder Nickel oder einer Golddrahtauflage o. dgl., um eine punktierte Verklebung mit Leitkleber zu ermöglichen.

Eine solche vorbeschriebene Leiterplatte (Inlet) für Chip-Karten ist rationell und damit äusserst kostengünstig herzustellen und erlaubt sowohl eine Kontaktierung des oder der Chips der Chip-Karte über genormte Anschlusskontakte als auch einen kontaktlosen Informationsaustausch über eine induktive Ankopplung oder über Radiowellen.

Ferner eignet sich eine solche vorbeschriebene Leiterplatte als sogenanntes Kombi-Inlet für die Herstellung einer Chip-Karte sowohl durch Laminieren als auch durch Umspritzen.

## Patentansprüche

1. Leiterplatte (Inlet) aus vorzugsweise thermoplastischem Kunststoff für Chip-Karten, dadurch gekennzeichnet, dass die Leiterplatte aus einer, eine Kontaktseite (1) und eine Montageseite (3) aufweisenden, beidseitig metallisierten Folie besteht, wobei auf der metallisierten Kontaktseite (1) Kontaktflächen (2) entsprechend der Norm der äusseren Anschlusskontakte und auf der metallisierten Montageseite (3) Anschlusskontakte (4) für den Chip (5) sowie Leiterbahnen (6) für die Spule sowie eine Leiterbahn (7) für den Spulenanschluss an den Chip angeordnet sind, wobei ferner die Durchkontaktierung zwischen den metallisierten Kontaktseite (1) und Montageseite (3) durch Bohrungen (8) im Trägermaterial hindurch erfolgt und wobei der Chip in flip-chip-Technik resp. ohne wire-bond-Verbindung mittels Leitkleber montiert ist.

2. Leiterplatte nach Anspruch 1, dadurch gekennzeichnet, dass die Kontaktflächen (2) auf der Kontaktseite (1) sowie die Anschlusskontakten (4) für den Chip (5), die Leiterbahnen (6) für die Spule und die Leiterbahn (7) zum Anschluss der Spule an den Chip durch Fotolithographie oder Siebdruck hergestellt sind.

3. Leiterplatte nach Anspruch 1, dadurch gekennzeichnet, dass die Durchkontaktierung zwischen den metallisierten Kontaktseite (1) und Montageseite (3) chemisch oder mittels Leiterpaste hergestellt ist.

4. Leiterplatte nach Anspruch 1, dadurch gekennzeichnet, dass die flip-chip-Technik mittels eines Polymer erfolgt, dessen Kontaktflächen Bumps (8') aufweisen und/oder für eine punktierte Verklebung mit Leitkleber Bumps an den Anschlussflächen des Chips ausgebildet sind in Form einer galvanisch oder chemisch aufgebrachten Überhöhung aus Gold, Kupfer oder Nickel oder einer Golddrahtauflage o. dgl..
